# EUROPEAN PATENT APPLICATION

(11) **EP 4 567 401 A1**
(43) Date of publication of application: **11.06.2025**
(21) Application number: 23849816.6
(22) Date of filing: 04.07.2023
(51) Int. Cl.: G01M 17/007

(54) **VERIFICATION-CYCLE GENERATION METHOD, VERIFICATION-CYCLE GENERATION SYSTEM, AND VERIFICATION-CYCLE GENERATION PROGRAM**

(30) Priority: 01.08.2022 JP 2022122839
(71) Applicant: HORIBA, Ltd., Kyoto-shi Kyoto 601-8510 (JP)
(72) Inventor: BATES, Luke, Warwickshire, CV100TU (GB); TABATA, Kunio, Warwickshire, CV100TU (GB); ROBERTS, Philip, Warwickshire, CV100TU (GB); WHELAN, Steven, Warwickshire, CV100TU (GB)
(74) Representative: Müller Hoffmann & Partner
(86) International application number: PCT/JP2023/024823
(87) International publication number: WO 2024/029257

(57) **Abstract**

The present invention is a verification-cycle generation method for generating a verification cycle for vehicle development, the verification cycle being a realistic one and satisfying boundary conditions for a plurality of vehicles, wherein a plurality of datasets concerning a drive cycle are input, the plurality of datasets are individually clustered and classified into a plurality of data groups, a plurality of verification cycles concerning vehicle development are generated on the basis of the plurality of clustered data groups, each of the plurality of verification cycles is carried out through simulation or with an actual machine, and a representative cycle that best satisfies user-defined criteria is selected from among the plurality of verification cycles.

## Description

### Technical Field

The present invention relates to a verification-cycle generation method, a verification-cycle generation device, and a verification-cycle generation program for use in vehicle development.

### Background Art

As shown, for example, in Non-Patent Document 1, conventionally, in vehicle development, validation tests for adverse conditions (boundary conditions) anticipated for vehicles on actual roads are conducted using a transient test cycle (verification cycle). The results of this validation test are then used to determine whether the vehicle development is successful or not successful. Typically, this verification cycle is created based on data acquired through driving on an actual road with a particular vehicle.

However, when driving on an actual road, the adverse conditions (boundary conditions) for the vehicle that are anticipated on the actual road vary depending on the driving environment, traffic conditions, route, driving style, or vehicle specifications such as the powertrain, etc. For example, in an RDE (Real Driving Emissions) test, the worst case when it comes to exhaust gas (boundary conditions) varies depending on the driving environment, traffic conditions, route, driving style, or vehicle specifications. Therefore, it is effectively impossible to cover the boundary conditions for many vehicles in a single verification cycle based on historical data and experience.

### Background Art References

### Non-Patent Literature

Non-Patent Literature 1: Michael Gorgen et al. "Holistic Hybrid RDE Calibration Methodology for EU7" FEV Engine Congress 2021 paper 14

### Summary of Invention

### Problem Solved by Invention

The present invention was made to solve the above problems, and its main object is to generate a realistic verification cycle that satisfies the boundary conditions of a plurality of vehicles.

### Solution to the Problem

The present invention relates to a verification-cycle generation method that generates a verification cycle for vehicle development, including: inputting a plurality of datasets concerning a drive cycle; clustering each of the plurality of datasets and classifying them into a plurality of data groups; generating a plurality of verification cycles related to vehicle development based on the plurality of data groups; and carrying out each of the plurality of verification cycles on a simulation device, on an actual machine, or on a combination thereof, and selecting a representative cycle that best satisfies user-defined criteria from among the plurality of verification cycles.

If this is the case, since a plurality of datasets concerning drive cycles are input, each of those plurality of datasets are clustered and classified into a plurality of data groups, and verification cycles concerning vehicle development are generated based on the clustered plurality of datasets, the system can generate realistic verification cycles that satisfy the boundary conditions for a plurality of vehicles.

In particular, in the present invention, a plurality of verification cycles related to vehicle development are generated, each of the plurality of verification cycles is carried out on the simulation device, an actual machine, or a combination thereof , and a representative cycle that best satisfies the criteria defined by the user is selected from the plurality of verification cycles, making it possible to generate a more realistic verification cycle (representative cycle) that satisfies the boundary conditions for the plurality of vehicles.

As a specific aspect of the datasets of the drive cycle, it is conceivable for the plurality of datasets to include vehicle speed information regarding vehicle speed and load information regarding load.

As a specific aspect of the datasets of the drive cycle, it is conceivable for the plurality of datasets to further include brake information regarding brakes or environmental factor information regarding environmental factors.

As a specific aspect of the generation of a plurality of verification cycles, it is conceivable that the plurality of verification cycles are generated by carrying out a series of processes a plurality of times, in which each of the plurality of datasets is clustered and classified into a plurality of data groups, and one verification cycle for vehicle development is generated based on the plurality of clustered data groups.

As a specific aspect for generating plausible verification cycles, it is conceivable that a verification cycle is generated from a plurality of clustered data groups using a Markov chain.

In order to increase the number of datasets and generated more realistic verification cycles, it is desirable that the dataset be adjusted by assigning a predetermined adjustment factor to the dataset to be input.

It is preferable that the user-defined criteria be a criterion for selecting the worst verification cycle, a criterion for selecting the best verification cycle, or a criterion for selecting the most frequently used verification cycle among the plurality of verification cycles.

In this configuration, the worst-case verification cycle is the one that meets the criteria for selecting the worst-case verification cycle. For example, in the case of an engine vehicle, this is the cycle with the highest fuel consumption or CO2 emissions, and in the case of an electric vehicle, this is the cycle with the worst electrical power consumption (or hydrogen consumption in the case of FCVs).

On the other hand, the best-case verification cycle is the one that meets the criteria for selecting the best verification cycle. For example, in the case of an engine vehicle, it is the cycle with the lowest fuel consumption or CO2 emissions, and in the case of an electric vehicle, it is the cycle with the best electrical power consumption (or hydrogen consumption in the case of FCV).

In order to be suitable for use in on-road emissions tests such as the RDE test, it is preferable that the verification cycle is one related to an on-road emissions test, and the plurality of input datasets include the vehicle speed information in the on-road emissions tests and the load information in the on-road emissions test.

In order to be suitable for use in on-road battery evaluation tests for vehicles with batteries, it is preferable the verification cycle is one related to an on-road battery evaluation test, and the plurality of input datasets include the vehicle speed information, the load information, and deceleration information related to deceleration in the on-road battery evaluation test. deceleration.

In order to be suitable for an on-road battery evaluation test, it is preferable that the deceleration information includes an amount of regeneration.

A verification-cycle generation devices according to the present invention is a verification-cycle generation device that generates a verification cycle for vehicle development, and includes: a dataset receiving unit that receives a plurality of datasets concerning a drive cycle; a clustering unit that clusters each of the plurality of datasets and classifies them into a plurality of data groups; a verification-cycle generation unit that generates a plurality of verification cycles related to vehicle development based on the plurality of data groups; and a simulation device, an actual machine (test equipment), or a combination thereof, that carries out each of the plurality of verification cycles.

A verification-cycle generation program according to the present invention is a verification-cycle generation program that generates a verification cycle for vehicle development, and that causes a computer to function as: a dataset receiving unit that receives a plurality of datasets concerning a drive cycle; a clustering unit that clusters each of the plurality of datasets and classifies them into a plurality of data groups; a verification-cycle generation unit that generates a plurality of verification cycles related to vehicle development based on the plurality of data groups; and a simulation unit that carries out each of the plurality of verification cycles.

### Effect of the Invention

The present invention as described above is able to generate a realistic verification cycle that satisfies the boundary conditions of a plurality of vehicles.

### Brief Description of Drawings

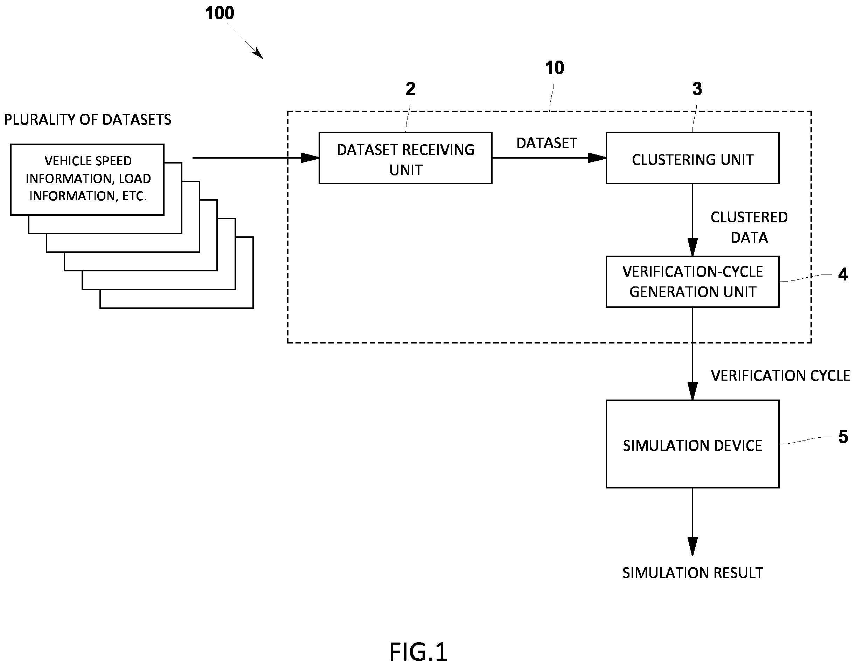

FIG 1: A figure schematically showing a configuration of a verification-cycle generation device according to one embodiment of the present invention.
FIG 2: A figure showing an example of clustering in the same embodiment.
FIG 3: A schematic figure of the same embodiment showing a generation method of a verification cycle using a Markov chain.
FIG 4: A schematic figure showing a generation method of a verification cycle of the same embodiment.
FIG 5: A schematic figure showing a generation method of a verification cycle of a variation embodiment.
FIG 6: A distribution diagram showing the distribution of CO2 emissions over a plurality of drive cycles.

### Embodiments for Carrying Out Invention

Below, a verification-cycle generation method and a verification-cycle generation system according to one embodiment of the present invention are explained with reference to the drawings.

### Device Configuration of the Verification-Cycle Generation System

The verification-cycle generation system 100 of the present embodiment generates a verification cycle used in vehicle development (including compatibility). Here, a vehicle includes, for example, an engine vehicle, hybrid vehicle, electric vehicle, or fuel cell vehicle.

Specifically, the verification-cycle generation system 100 includes a dataset receiving unit 2 that receives a plurality of datasets concerning drive cycles, a clustering unit 3 that clusters each of the plurality of datasets and classifies them into a plurality of data groups, a verification-cycle generation unit 4 that generates a plurality of verification cycles related to vehicle development based on a plurality of clustered data groups, and a simulation device 5 that carries out each of the plurality of verification cycles.

In the present embodiment, the dataset receiving unit 2, the clustering unit 3, and the verification-cycle generation unit 4 are configured on a cycle generation device 10 (a computer with a CPU, internal memory, an input/output interface, etc.) different from the simulation device 5. It is also possible for the dataset receiving unit 2, the clustering unit 3, and the verification-cycle generation unit 4 to be configured on a common computer with the simulation device; moreover, the dataset receiving unit 2, the clustering unit 3, and the verification-cycle generation unit 4 may each be configured on separate computers from each other.

The dataset receiving unit 2 receives a plurality of datasets concerning the drive cycle. Here, the plurality of datasets include datasets obtained in the past and/or datasets of simulation results obtained by simulation devices such as a digital twin or the like. The plurality of datasets are ones that meet the criteria for the drive cycle as stipulated by law and regulation or the like; for example, if the drive cycle is one specified by the RDE, then the datasets are ones that satisfy the RDE test criteria.

Each dataset also contains vehicle speed information regarding vehicle speed and load information regarding load. Here, the vehicle speed information is, for example, vehicle speed, engine rotation speed or motor rotation speed. The load information is one or more factors that determine the amount of load; for example, the amount the accelerator is being pressed (accelerator pedal position), the throttle opening amount, the fuel injection amount, the torque demand, the power demand, the hydrogen demand, or the air (oxygen) demand. Moreover, each dataset may further include brake information concerning braking or environmental factor information concerning environmental factors. Here, brake information is, for example, the amount the brake is being pressed (brake position) The environmental factor information is, for example, air pressure, pressure, temperature, humidity, road surface conditions (road surface µ, road surface roughness), or road conditions (the amount of traffic congestion).

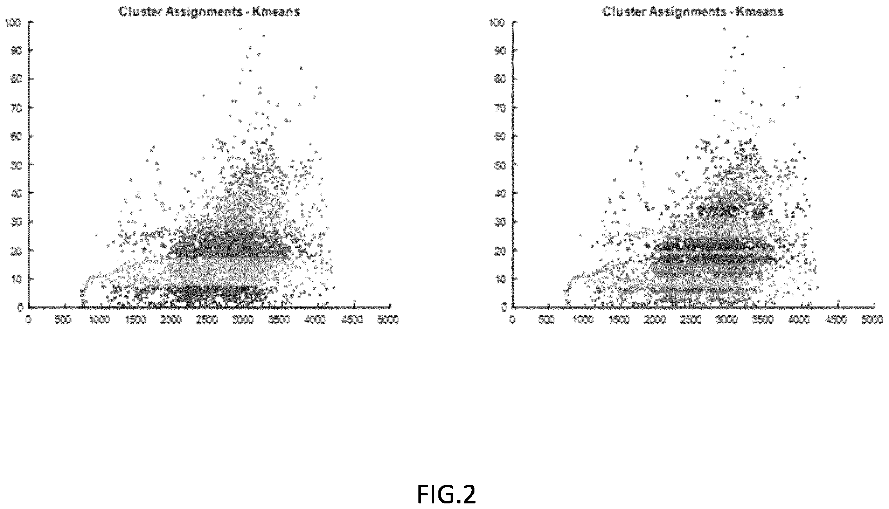

The clustering unit 3 clusters each of the plurality of datasets received by the dataset receiving unit 2 and classifies them into a plurality of data groups. Non-hierarchical clustering, such as the k-means method or the fuzzy clustering (group) method, for example, may be used as the clustering method of the clustering unit 3. FIG 2 shows a graph of clustering using the k-means method. In this graph, the vertical axis is the engine rotation speed (vehicle speed) and the horizontal axis is the accelerator opening position. Furthermore, the clustering unit 3 clusters the plurality of datasets into a plurality of categories; for example, 'hard acceleration,' 'mild acceleration,' 'constant speed,' 'mild deceleration,' 'hard deceleration,' and/or 'stop.'

The verification-cycle generation unit 4 generates a verification cycle for vehicle development based on the plurality of data groups clustered by the clustering unit. Specifically, the verification-cycle generation unit 4 generates a verification cycle from a plurality of data groups using a Markov chain.

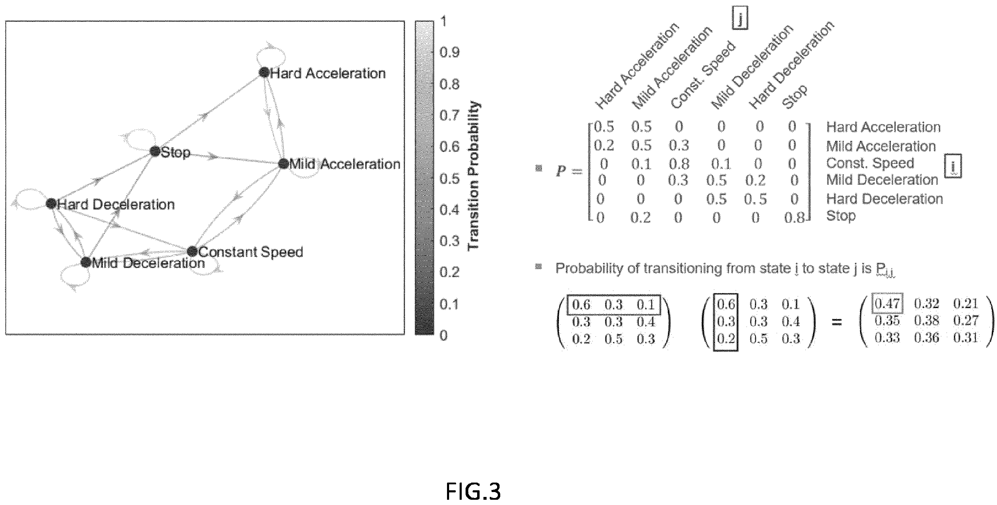

As shown in FIG 3, the verification-cycle generation unit 4 creates the most likely drive pattern by calculating the probability that a next node is likely to occur from a given node, and connecting the nodes with the highest probability.

Here, each node is a single piece of data indicating 'engine rotation speed - accelerator opening position' and is classified into a plurality of clustered categories ('Hard Acceleration', 'Mild Acceleration', 'Constant Speed', 'Mild Acceleration', 'Hard Acceleration' and/or 'Stop'). The transition probabilities between a plurality of nodes are calculated, and the nodes are connected based on these transition probabilities to generate the most likely drive pattern (verification cycle). Moreover, FIG 3 shows a transition probability matrix of transitions from 'i' to 'j' for each node included in the above six categories, and a numerical example for transitioning from the 'Hard Acceleration' node to the 'Hard Acceleration' node.

The verification cycle generated by the verification-cycle generation unit 4 is verified by a simulation device 5. This simulation device 5 may be, for example, a simulation device known as a digital twin. Moreover, in order to enable the execution of the verification cycle, data such as the driving environment, traffic conditions, route, driving style, or vehicle specifications are input into the simulation device 5 ahead of time.

### Verification-Cycle Generation Method

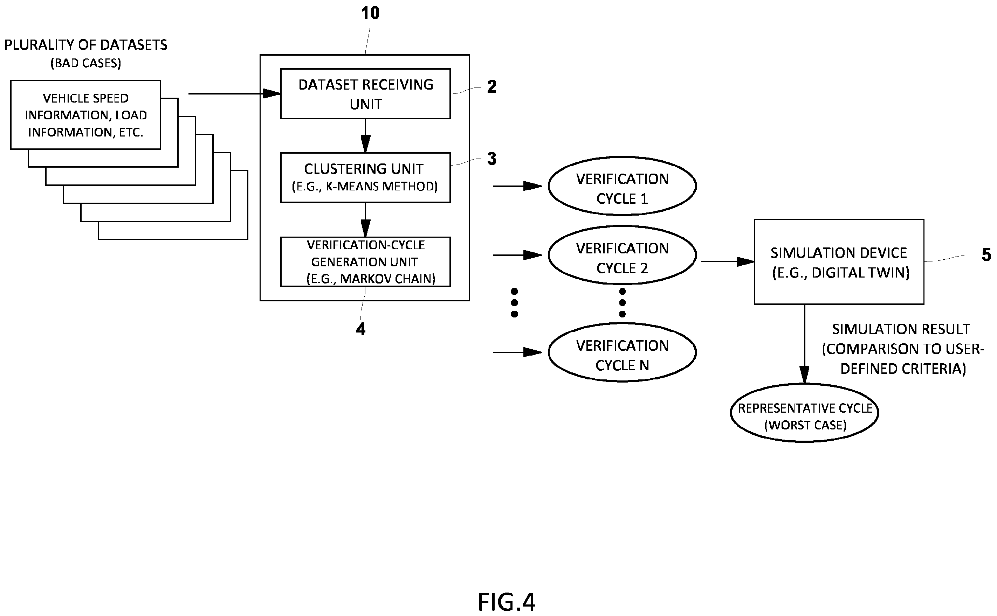

Next, the verification-cycle generation method using the verification-cycle generation system of the present embodiment is described with reference to FIG 4. The following section describes an example of generating a verification cycle with the highest CO2 emissions (the worst-case verification cycle) in an on-road emissions test.

A plurality of datasets of various drive cycles in the on-road emissions test are input to the dataset receiving unit 2. Here, the plurality of datasets include real datasets obtained in the past and/or virtual datasets of simulation results obtained by simulation devices such as a digital twin or the like. The plurality of datasets in the present embodiment include a real dataset in the cycle with the highest CO2 emissions (a bad case real dataset) and/or a virtual dataset in the cycle with the highest CO2 emissions (a bad case virtual dataset).

Then, each of the plurality of datasets are clustered and classified into a plurality of data groups by the clustering unit 3. In this example, they are clustered into the six categories of 'hard acceleration,' 'mild acceleration,' 'constant speed,' 'mild deceleration,' 'hard deceleration,' and 'stop.'

Next, the verification-cycle generation unit 4 generates one verification cycle of an on-road emissions test related to vehicle development using a Markov chain based on the plurality of clustered data groups. The verification cycle generated by the verification-cycle generation unit 4 is the verification cycle that is expected to have the highest CO2 emissions.

In the present embodiment, as described above, a plurality of verification cycles are generated by carrying out a series of processes a plurality of times, in which each of the plurality of datasets is clustered and classified into a plurality of data groups, and one verification cycle for vehicle development is generated based on the plurality of clustered data groups.

Then, each of the plurality of verification cycles is carried out by the simulation device 5, and a representative cycle that best satisfies the user-defined criteria is selected from the plurality of verification cycles. The user-defined criteria of the present embodiment is a criterion of selecting the worst verification cycle among the plurality of verification cycles. That is, a plurality of verification cycles are executed as a simulation, and the verification cycle with the largest amount of CO2 emissions is selected as the representative cycle.

### Effect of the Present Embodiment

According to the verification-cycle generation method of the present embodiment, a plurality of datasets regarding drive cycles are input, each of the plurality of datasets is clustered and classified into a plurality of data groups, and a verification cycle for vehicle development is generated based on the plurality of clustered data groups, so that a realistic verification cycle that satisfies the boundary conditions for a plurality of vehicles can be generated.

In particular, in the present embodiment, a plurality of verification cycles related to vehicle development are generated, each of the plurality of verification cycles is carried out on the simulation device 5, and a representative cycle that best satisfies the criteria defined by the user is selected from the plurality of verification cycles, making it possible to generate a more realistic verification cycle (representative cycle) that satisfies the boundary conditions for the plurality of vehicles.

Moreover, in the present embodiment, by using datasets acquired in the past as well as simulation data obtained from digital twins, etc., and applying techniques from probability theory such as clustering and Markov chains, more realistic verification cycle cans be created that satisfies given boundary conditions that match the vehicle being evaluated. Vehicles that have been evaluated through these verification cycles can then be made to be more robust than those validated through evaluations performed through conventional empirical verification cycles. Furthermore, according to the present embodiment, it is possible to perform driving under environmental conditions and via driving styles that are not possible in reality by using a simulation device, and incorporate these into the dataset that is input.

### Other Embodiments

Moreover, the present invention is not limited to the above-described embodiment.

For example, in the above embodiment, the generated verification cycle is carried out by the simulation device 5 to determine whether or not it is the cycle that best satisfies the criteria defined by the user; however, it is also possible to execute the verification cycle using, for example, an actual machine (test equipment) or a combination of the actual machine and the simulation device 5 to determine whether or not it is the cycle that best satisfies the criteria defined by the user. Here, the actual machine (test equipment) includes a chassis dynamometer, an engine dynamometer, a motor dynamometer, a driveline dynamometer, or the like.

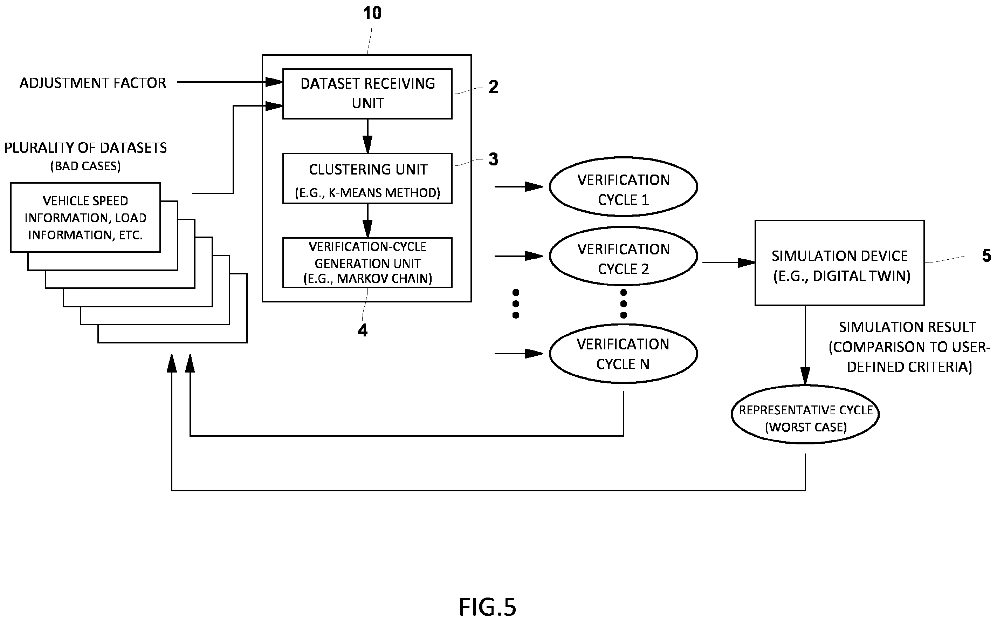

As shown in FIG 5, it is also possible for the dataset to be adjusted by assigning a predetermined adjustment factor to the dataset to be input. This configuration can not only increase the number of pieces of data to be input, but also can make it easier to generate cycles that best meet user-defined criteria (e.g., cycles with worse results) by adjusting the adjustment factor.

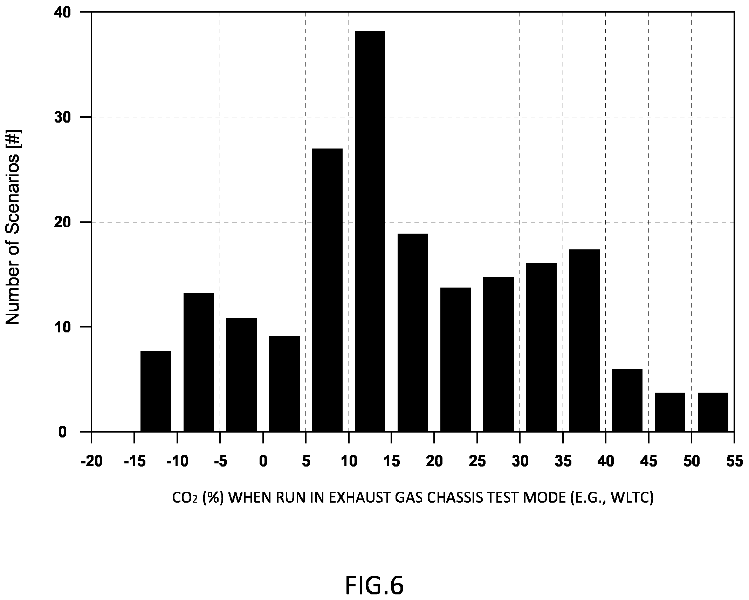

Furthermore, as shown in FIG 6, the verification cycle generated by the verification-cycle generation unit 4 may be input to the dataset receiving unit 2 as a plurality of datasets, or a representative cycle may be input to the dataset receiving unit 2 as a plurality of datasets. The verification cycle generated in this manner can be turned into inputs again to make the representative cycle more consistent with the aforementioned criteria.

In the above embodiment, the worst verification cycle is selected among the plurality of verification cycles, but the verification cycle with the best results may be selected, or the verification cycle most frequently used by the user, or the verification cycle with the average result may be selected. As shown in FIG 6, here the verification cycle most frequently used by the user is included in the most frequent CO2 emissions range in the distribution of CO2 emissions over a plurality of drive cycles.

Besides this, although the exhaust gas test of the above embodiment measures carbon dioxide (CO2), the exhaust gas test may also be one that measures carbon monoxide (CO), nitrogen oxides (NOX), hydrocarbons (CH), total hydrocarbons (THC), ammonium (NH3), formaldehyde (HCHO), dinitrogen monoxide (N2O), particulate matter (PM), and/or PM particle number (PN), etc., as components in the exhaust gas.

Moreover, the above embodiments generate a verification cycle related to exhaust gas testing, but it is also possible for it to generate a verification cycle related to on-road battery evaluation testing. In this case, the plurality of datasets to be input would include vehicle speed information, load information, and/or deceleration information regarding deceleration in the on-road battery evaluation test. In addition, deceleration information includes the amount that the brake is being pressed or the amount of regeneration or the like. It is also possible to generate a verification cycle for fuel consumption evaluation testing, a verification cycle for electrical power consumption evaluation testing, a verification cycle for hydrogen consumption evaluation testing, a verification cycle for brake dust evaluation testing, or a verification cycle for tire dust evaluation testing.

When it comes to these verification cycles for evaluation tests, although it is possible to create various verification cycles to meet user-defined criteria here too, a possible verification cycle as an example of a worst-case scenario will be described as an example. For example, the verification cycle related to on-road battery evaluation testing could generate the verification cycle with the highest power consumption. For example, the verification cycle related to fuel consumption evaluation testing could generate the verification cycle with the highest fuel consumption. For example, the verification cycle related to electrical power consumption evaluation testing could generate the verification cycle with the highest electrical power consumption. For example, the verification cycle related to hydrogen consumption evaluation testing could generate the verification cycle with the highest hydrogen consumption. For example, the verification cycle related to the brake dust or tire dust evaluation testing could generate the verification cycle with the highest amount of brake dust or tire dust.

Various other variations and combinations of embodiments may be made as long as they do not contradict the purpose of the present invention.

### Industrial Applicability

According to the present invention, it is possible to generate a realistic verification cycle that satisfies the boundary conditions of a plurality of vehicles.

### Explanation of Reference Signs

100 verification-cycle generation system
10 cycle generation device
2 dataset receiving unit
3 clustering unit
4 verification-cycle generation unit
5 simulation device

## Claims

1. A verification-cycle generation method that generates a verification cycle for vehicle development, comprising:
inputting a plurality of datasets concerning a drive cycle;
clustering each of the plurality of datasets and classifying them into a plurality of data groups;
generating a plurality of verification cycles related to vehicle development based on the plurality of data groups; and
carrying out each of the plurality of verification cycles on a simulation device, on an actual machine, or on a combination thereof, and selecting a representative cycle that best satisfies user-defined criteria from among the plurality of verification cycles.

2. The verification-cycle generation method according to claim 1, wherein the dataset includes vehicle speed information regarding vehicle speed and load information regarding load.

3. The verification-cycle generation method according to claim 2, wherein the dataset further includes brake information regarding brakes or environmental factor information regarding environmental factors.

4. The verification-cycle generation method according to any one of claims 1 to 3, wherein a plurality of verification cycles are generated by carrying out a series of processes a plurality of times, in which each of the plurality of datasets is clustered and classified into a plurality of data groups, and one verification cycle for vehicle development is generated based on the plurality of clustered data groups.

5. The verification-cycle generation method according to any one of claims 1 to 4, wherein a verification cycle is generated from a plurality of clustered data groups using a Markov chain.

6. The verification-cycle generation method according to any one of claims 1 to 5, wherein the dataset is adjusted by assigning a predetermined adjustment factor to the dataset to be input.

7. The verification-cycle generation method according to any one of claims 1 to 6, wherein the user-defined criteria is a criterion for selecting the worst verification cycle, a criterion for selecting the best verification cycle, or a criterion for selecting the most frequently used verification cycle among the plurality of verification cycles.

8. The verification-cycle generation method according to any one of claims 1 to 7, wherein
the verification cycle is one related to an on-road emissions test, and
the plurality of input datasets include the vehicle speed information and the load information in the on-road emissions test.

9. The verification-cycle generation method according to any one of claims 1 to 7, wherein
the verification cycle is one related to an on-road battery evaluation test, and
the plurality of input datasets include the vehicle speed information, the load information, and deceleration information related to deceleration in the on-road battery evaluation test.

10. The verification-cycle generation method according to claim 9, wherein the deceleration information includes an amount of regeneration.

11. A verification-cycle generation system that generates a verification cycle for vehicle development, comprising:
a dataset receiving unit that receives a plurality of datasets concerning a drive cycle;
a clustering unit that clusters each of the plurality of datasets and classifies them into a plurality of data groups;
a verification-cycle generation unit that generates a plurality of verification cycles related to vehicle development based on the plurality of data groups; and
a simulation device, an actual machine, or a combination thereof, that carries out each of the plurality of verification cycles.

12. A verification-cycle generation program that generates a verification cycle for vehicle development, and that causes the computer to function as:
a dataset receiving unit that receives a plurality of datasets concerning a drive cycle;
a clustering unit that clusters each of the plurality of datasets and classifies them into a plurality of data groups;
a verification-cycle generation unit that generates a plurality of verification cycles related to vehicle development based on the plurality of data groups; and
a simulation unit that carries out each of the plurality of verification cycles.
